Europäisches Patentamt

European Patent Office

Office européen des brevets

(11) Publication number: **0 183 850 B1**

## EUROPEAN PATENT SPECIFICATION
## published in accordance with Art. 158(3) EPC

(45) Date of publication of patent specification: 04.09.91    (51) Int. Cl.⁵: **H02M 7/04**

(21) Application number: 85902158.6

(22) Date of filing: 08.05.85

(86) International application number:
PCT/JP85/00254

(87) International publication number:
**WO 85/05233 (21.11.85 85/25)**

(54) **HIGH-TENSION THYRISTOR CONVERTER.**

(30) Priority: 08.05.84 JP 93499/84

(43) Date of publication of application:
**11.06.86 Bulletin 86/24**

(45) Publication of the grant of the patent:
**04.09.91 Bulletin 91/36**

(84) Designated Contracting States:
**CH DE LI SE**

(56) References cited:
JP-B- 5 147 578
JP-B- 5 338 027
JP-B- 5 845 243
US-A- 4 142 230

**PATENTS ABSTRACTS OF JAPAN, vol. 8, no.
285 (E-287)[1722], 26th December 1984; JP-
A-59 150 462 (TOSHIBA K.K.) 28-08-1984**

(73) Proprietor: **MITSUBISHI DENKI KABUSHIKI**

**KAISHA
2-3, Marunouchi 2-chome Chiyoda-ku
Tokyo 100(JP)**

(72) Inventor: **YOSHIZUMI, Toshiaki Mitsubishi De-
nki Kabushiki
Kaisha Itami Seisakusho 1-1, Tukaguchi hon-
machi
8-chome Amagasaki-shi Hyogo 661(JP)**

(74) Representative: **Sajda, Wolf E., Dipl.-Phys. et
al
MEISSNER, BOLTE & PARTNER Widenmayer-
strasse 48 Postfach 86 06 24
W-8000 München 86(DE)**

## Description

The invention relates to a high-voltage thyristor conversion/inversion apparatus, comprising a bridge circuit which is constructed of valves of six arms and lightning arresters which are connected in parallel with the respective valves and where corresponding valves are kept in sealed tanks with an insulating medium. Apparatus of this type can be used for example in an A.C.-D.C. converting/inverting station.

A high-voltage thyristor conversion/inversion apparatus as specified above is known for example from US-A-4 142 230 which is to provide a sealed D.C. electric power converting station in which constructional units or elements are connected through $SF_6$ gas insulated conduit bus bars, with each unit or element being arranged so that the thyristors can be maintained and inspected periodically or exchanged easily.

For this reason, in the apparatus according to US-A-4 142 230 quite a number of separate units are provided which are connected with each other through disconnectable conduit-type bus bars. Also, the respective units may be provided with wheels which are movable on respective rails for inspection and maintenance purposes. Since all the units are provided in separate containers a large space is required for the power converting station according to the prior art represented by US-A-4 142 230.

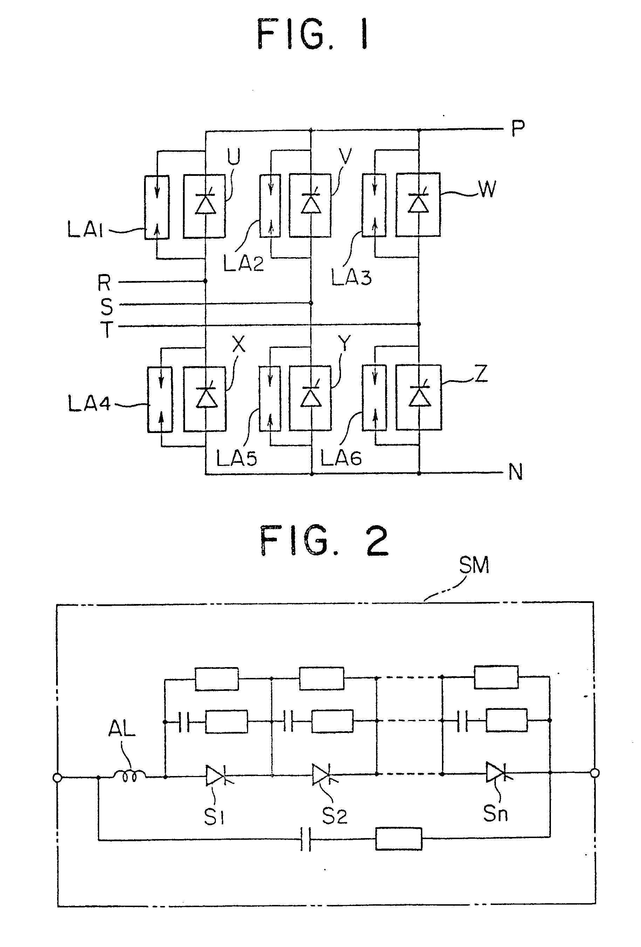

Fig. 1 shows a connection diagram of a high-voltage thyristor conversion/inversion apparatus to which the invention is directed. By this apparatus alternating current supplied from A.C. buses R, S and T is converted into direct current through bridge-connected valves U, V, W, X, Y and Z, or direct current supplied from D.C. buses P and N is inverted into alternating current. Lightning arresters LA1, LA2, LA3, LA4, LA5 and LA6 are connected in parallel with the bridge-connected valves U to Z in order to protect the respective valves U to Z from overvoltages.

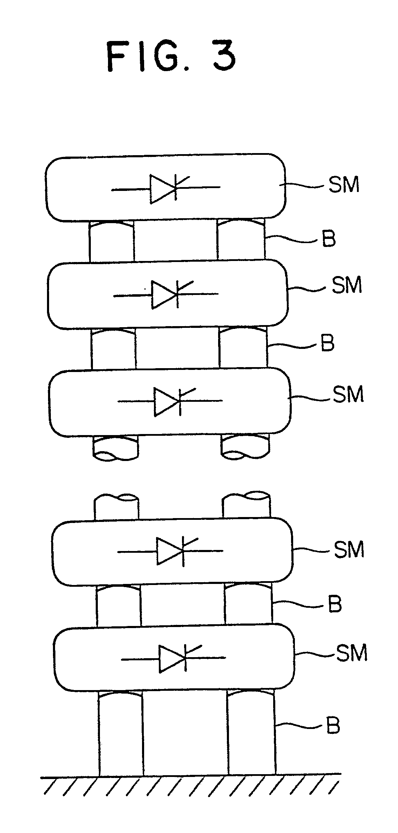

Each of the valves U to Z constituting the high-voltage thyristor conversion/inversion apparatus is constructed in such a way that thyristor modules SM, each of which comprises a plurality of thyristor elements S1, S2,... Sn as well as an anode reactor AL belonging thereto, and resistors and capacitors as shown in Fig. 2, are stacked in a required number by the use of insulating bars B as shown in Fig. 3.

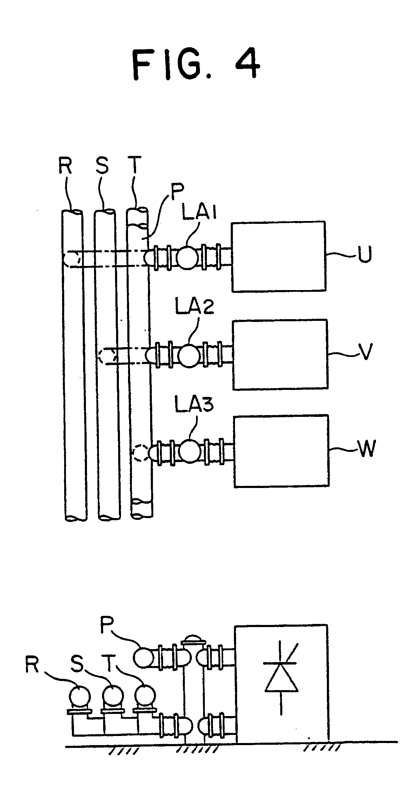

Fig. 4 shows an example of this prior art arrangement of thyristor valves as used in practice, and depicts a portion corresponding to three arms in a rectifier bridge which is composed of six arms of valves.

The valves U, V and W constituting the bridge circuit are respectively received in separate sealed tanks so as to be protected from dust in the air. This sealed tanks are usually filled up with an insulating oil or insulating gas in order to enhance an insulation performance. The A.C. buses R, S and T and the D.C. bus P are connected to these valves, while the lightning arresters LA1, LA2 and LA3 for protecting these valves are connected in parallel with them.

In the prior-art thyristor conversion/inversion apparatus, wherein the individual valves U, V and W constituting the bridge circuit are housed in separate sealed tanks, the arrangement becomes large in size, and the A.C. buses and the D.C. buses intersect each other in a complicated manner, as illustrated in Fig. 4.

Accordingly, the object underlying the present invention is to improve a high-voltage thyristor conversion/inversion apparatus by reducing the size of the whole apparatus.

According to the invention, this problem is solved in that the valves and the lightning arresters of each portion corresponding to three arms, which are connected to a D.C. bus of identical sign, are collectively received inside a single sealed tank; in that the valves are arranged concentrically at equal intervals in the sealed tank; in that the lightning arresters, each of which is disposed on one side of the corresponding valve, are arrayed in a straight line; in that the A.C. buses collected for the three phases are connected to the respective valves via anode reactors each of which is disposed on one side of the corresponding valve; and in that the A.C. buses are collectively led into the sealed tank through a first insulated spacer while the D.C. bus is led out of the sealed tank through a second insulated spacer.

A further development of the apparatus according to the invention is characterized in that the A.C. buses are led into the tank close to the bottom thereof through an opening of a branch pipe and the D.C. bus is led out of the tank in a top part thereof through an opening of another branch pipe.

A further development of the apparatus according to the invention is characterized in that the output sides of the valves and the lightning arresters are connected by joint conductors which are collectively coupled to a joint conductor connected to the D.C. bus.

A specific embodiment of the apparatus according to the invention is characterized in that a cooling device is provided and connected to the single sealed tank for cooling the insulated medium and the valves inside the sealed tank.

According to a further development, the apparatus according to the invention is characterized in that on a base of the sealed tank insulating pillars are fixed which support the valves and the lightning arresters while insulating them from the sealed tank.

According to the invention, the object underlying the present invention is solved in an advantageous manner wherein the construction of the apparatus can be simplified while maintaining a reliable operation.

The invention will be explained in detail below with reference to the accompanying drawings, wherein

Fig. 1 is a connection diagram of a high-voltage thyristor conversion/inversion apparatus;

Fig. 2 is a connection diagram of the thyristor module thereof;

Fig. 3 is a view of the internal setup of each valve;

Fig. 4 is a view of the arrangement of a prior art high-voltage thyristor conversion/inversion apparatus;

Fig. 5 is a sectional view, seen from below, of a high-voltage thyristor conversion/inversion apparatus according to the invention;

Fig. 6 is a plan view, partly in section, of the high-voltage thyristor conversion/inversion apparatus seen from the above; and

Fig. 7 is a side view, partly in section, of the high-voltage thyristor conversion/inversion apparatus according to the invention.

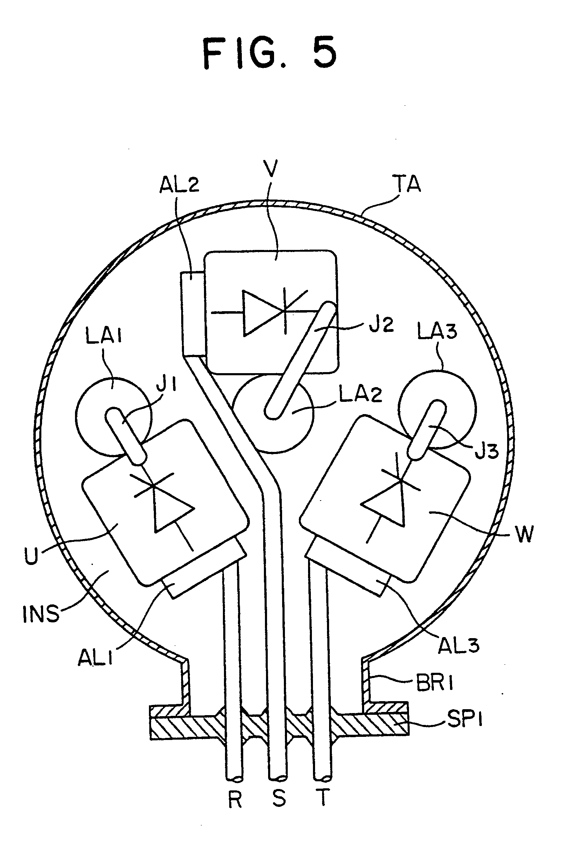

In the following, reference is made to Fig. 5 showing a sectional view of the high-voltage thyristor conversion/inversion apparatus wherein the valves are seen from below. Among the valves constituting a bridge circuit, valves U, V and W corresponding to three arms are collectively received in a cylindrical sealed tank TA. This sealed tank TA is filled up with an insulating medium INS of high dielectric strength, for example an insulating oil or insulating gas, resulting in that the insulation distances between the sealed tank TA and the valves U, V and W can be shortened.

The sealed tank TA is provided with an opening BR1 in the shape of a branch pipe, and an insulating spacer SP1 is mounted on the sealed tank TA in a manner to cover up the opening BR1.

A.C. buses R, S and T corresponding to three phases are collectively led inwards from outside the sealed tank TA while penetrating through the insulating spacer SP1; the A.C. buses R, S and T are respectively connected to the valves U, V and W via anode reactors AL1, AL2 and AL3, each being disposed on one side of the corresponding valve.

In the sealed tank TA, the valves U, V and W are arranged concentrically at equal intervals. Since the section of each valve U, V or W usually forms a rectangle as shown in Fig. 5, wasteful spaces arise when the valves U, V and W corresponding to the three arms are collectively installed inside the sealed tank TA. Therefore, by utilizing these spaces, lightning arresters LA1, LA2 and LA3 juxtaposed to the respective valves U, V and W are arrayed in a straight line as shown in Fig. 5, wherein they are connected in parallel with the respective valves U, V and W through joint conductors J1, J2 and J3.

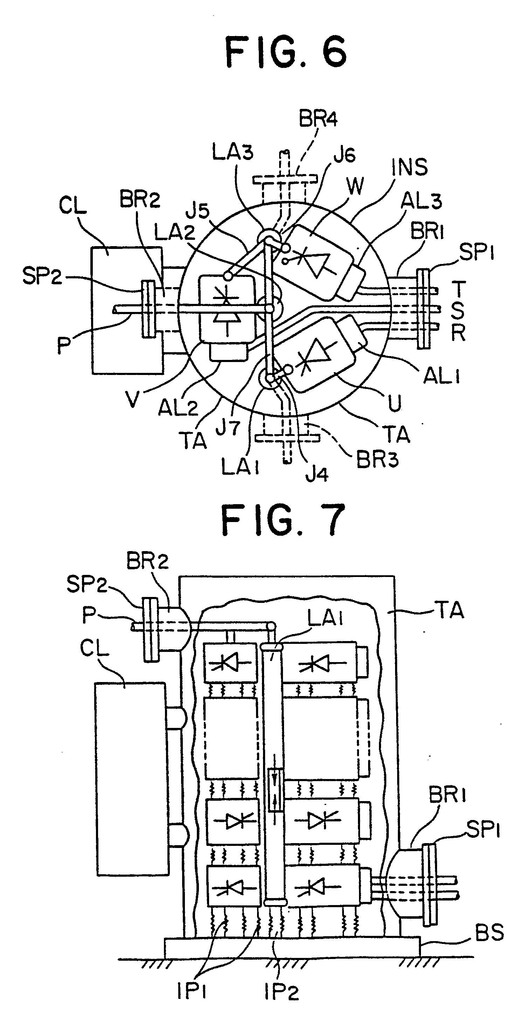

Fig. 6 shows a plan view of the high-voltage thyristor conversion/inversion apparatus according to the invention wherein the collected valves of the three arms having a construction as described above are seen from above, while Fig. 7 shows a side view of this apparatus, wherein both Figs. 6 and 7 are views partly in section.

In the arrangement according to Fig. 6, joint conductors J4, J5 and J6 serve to connect the valves U, V and W and the lightning arresters LA1, LA2 and LA3 in a top part thereof, wherein they are collectively coupled to a joint conductor J7 to be connected thereby to the D.C. bus P.

The D.C. bus P is led out of the sealed tank TA while penetrating through a branch pipe BR2 and a spacer SP2 with which the sealed tank TA is provided. The branch pipe BR2 can be mounted in any desired direction as can be understood from the illustrated embodiment, and it may well be mounted, for example, in a position BR3 or BR4 as indicated by dotted lines in Fig. 6. A cooling device CL indicated in Figs. 6 and 7 is for cooling the insulating medium INS and the valves U, V and W inside the sealed tank TA.

As can be seen in Fig. 7, insulating pillars IP1 and IP2 are fixed on a base BS and support the valves U, V and W and the lightning arresters LA1, LA2 and LA3 while insulating them from the sealed tank TA.

The outgoing ends of the three-phase A.C. buses R, S and T and the D.C. bus P can be connected directly to a bushing and a cable head, and they can also be connected with other equipment, for example by the use of conduit aerial buses.

In particular, the three-phase A.C. buses R, S and T have the three-phase portion collected and can therefore have the A.C. side lead-in thereof connected directly with conduit aerial buses collected for three phases, so that the construction of a converting/inverting station can be simplified and scaled down extremely.

It is needless to say that the arrangements of the valves U, V and W and the lightning arresters LA1, LA2 and LA3 inside the sealed tank TA may be modified within the scope defined by the claims. Also, the sectional shape of the sealed tank TA can be modified, namely, the circular shape shown in the drawings may be replaced by the shape of an ellipse or a rectangle.

## Claims

1. A high-voltage thyristor conversion/inversion apparatus, comprising a bridge circuit which is constructed of valves (U, V, W) of six arms and lightning arresters (LA1, LA2, LA3) which are connected in parallel with the respective valves and where corresponding valves are kept in sealed tanks with an insulating medium,
characterized in that the valves (U, V, W) and the lightning arresters (LA1, LA2, LA3) of each portion corresponding to three arms, which are connected to a D.C. bus (P) of identical sign, are collectively received inside a single sealed tank (TA),
in that the valves (U, V, W) are arranged concentrically at equal intervals in the sealed tank (TA),
in that the lightning arresters (LA1, LA2, LA3), each of which is disposed on one side of the corresponding valve (U, V, W), are arrayed in a straight line,
in that the A.C. buses (R, S, T) collected for the three phases are connected to the respective valves (U, V, W) via anode reactors (AL1, AL2, AL3) each of which is disposed on one side of the corresponding valve (U, V, W),
and in that the A.C. buses (R, S, T) are collectively led into the sealed tank (TA) through a first insulated spacer (SP1) while the D.C. bus (P) is led out of the sealed tank (TA) through a second insulated spacer (SP2).

2. The apparatus according to claim 1,
characterized in that the A.C. buses (R, S, T) are led into the tank (TA) close to the bottom thereof through an opening (BR1) of a branch pipe and the D.C. bus (P) is led out of the tank (TA) in a top part thereof through an opening (BR2, BR3, BR4) of another branch pipe.

3. The apparatus according to claim 1 or 2,
characterized in that the output sides of the valves (U, V, W) and the lightning arresters (LA1, LA2, LA3) are connected by joint conductors (J4, J5, J6) which are collectively coupled to a joint conductor (J7) connected to the D.C. bus (P).

4. The apparatus according to any of claims 1 to 3,
characterized in that a cooling device (CL) is provided and connected to the single sealed tank (TA) for cooling the insulated medium (INS) and the valves (U, V, W) inside the sealed tank (TA).

5. The apparatus according to any of claims 1 to 4,
characterized in that on a base (BS) of the sealed tank (TA) insulating pillars (IP1, IP2) are fixed which support the valves (U, V, W) and the lightning arresters (LA1, LA2, LA3) while insulating them from the sealed tank (TA).

## Revendications

1. Appareil convertisseur/inverseur à thyristors à haute tension, comprenant un montage en pont qui est composé de valves (U, V, W) de six bras et de parafoudres (LA1, LA2, LA3) qui sont connectés en parallèle avec les valves respectives et dans lequel les valves correspondantes sont maintenues dans des cuves hermétiquement fermées contenant un milieu isolant,
caractérisé en ce que les valves (U, V, W) et les parafoudres (LA1, LA2, LA3) de chaque partie correspondant à trois bras, qui sont connectés à une barre omnibus (P) de courant continu de signe identique, sont logés collectivement à l'intérieur d'une cuve hermétiquement fermée unique (TA),
en ce que les valves (U, V, W) sont disposées concentriquement à intervalles égaux dans la cuve hermétiquement fermée (TA),
en ce que les parafoudres (LA1, LA2, LA3), qui sont chacun placés sur un côté de la valve correspondante (U, V, W), sont disposés en ligne droite,
en ce que les barres omnibus de courant alternatif (R, S, T), collectant les trois phases, sont connectées aux valves respectives (U, V, W) par l'intermédiaire de bobines de réaction anodiques (AL1, AL2, AL3) qui sont chacune placées sur un côté de la valve correspondante (U, V, W)
et en ce que les barres omnibus de courant alternatif (R, S, T) sont amenées collectivement dans la cuve hermétiquement fermée (TA) à travers une première pièce d'espacement isolée (SP1) alors que la bare omnibus de courant continu (P) est amenée vers l'extérieur de la cuve hermétiquement fermée (TA) à travers une seconde pièce d'espacement isolée (SP2).

2. Appareil selon la revendication 1,
caractérisé en ce que les barres omnibus de courant alternatif (R, S, T) sont amenées dans la cuve hermétiquement fermée au voisinage du fond de celle-ci, à travers une ouverture (BR1) d'un tuyau de dérivation et la barre omnibus de courant continu (P) est amenée vers l'extérieur de la cuve (TA), à la partie supérieure de celle-ci, à travers une ouverture (BR2, BR3, BR4) d'un autre tuyau de dérivation.

3. Appareil selon la revendication 1 ou 2, caractérisé en ce que les côtés de sortie des valves (U, V, W), et les parafoudres (LA1, LA2, LA3) sont raccordés par des conducteurs de jonction (J4, J5, J6) qui sont collectivement couplés à un conducteur de jonction (J7) raccordé à la barre omnibus de courant continu.

4. Appareil selon l'une des revendications 1 à 3, caractérisé en ce qu'il est muni d'un dispositif de refroidissement (CL) connecté à la cuve hermétiquement fermée unique (TA) afin de refroidir le milieu isolé (INS) et les valves (U, V, W) à l'intérieur de la cuve hermétiquement fermée (TA).

5. Appareil selon l'une des revendications 1 à 4, caractérisé en ce que des piliers isolants (IP1, IP2), supportant les valves (U, V, W) et les parafoudres (LA1, LA2, LA3) tout en les isolant de la cuve hermétiquement fermée (TA), sont fixés sur une base (BS) de la cuve hermétiquement fermée (TA).

**Patentansprüche**

1. Hochspannungs-Thyristorvorrichtung zum Umrichten/Wechselrichten, umfassend eine Brückenschaltung, die aus Ventilen (U, V, W) mit sechs Armen und Überspannungsableitern (LA1, LA2, LA3) aufgebaut ist, die parallel zu den jeweiligen Ventilen geschaltet sind, und wobei entsprechende Ventile in dichten Tanks mit einem Isoliermedium untergebracht sind, dadurch gekennzeichnet, daß die Ventile (U, V, W) und die Überspannungsableiter (LA1, LA2, LA3) von jedem Bereich, entsprechend den drei Armen, die mit einer Gleichstrom-Sammelschiene (P) mit identischem Vorzeichen verbunden sind, gemeinsam im Inneren eines einzigen dichten Tanks (TA) untergebracht sind, daß die Ventile (U, V, W) konzentrisch in gleichen Abständen in dem dichten Tank (TA) angeordnet sind, daß die Überspannungsableiter (LA1, LA2, LA3), die jeweils auf der einen Seite des entsprechenden Ventils (U, V, W) vorgesehen sind, in einer geraden Linie angeordnet sind, daß die Wechselstrom-Sammelschienen (R, S, T) gesammelt für die drei Phasen an die jeweiligen Ventile (U, V, W) über Anodendrosseln (AL1, AL2, AL3) angeschlossen sind, die jeweils auf der einen Seite des entsprechenden Ventils (U, V, W) angeordnet sind,

und daß die Wechselstrom-Sammelschienen (R, S, T) durch einen ersten isolierten Abstandshalter (SP1) gemeinsam in den dichten Tank (TA) geführt sind, während die Gleichstrom-Sammelschiene (P) durch einen zweiten isolierten Abstandshalter (SP2) aus dem dichten Tank (TA) herausgeführt ist.

2. Vorrichtung nach Anspruch 1, dadurch gekennzeichnet, daß die Wechselstrom-Sammelschienen (R, S, T) in den Tank (TA) dicht an dessen Boden durch eine Öffnung (BR1) eines Abzweigrohres hineingeführt und die Gleichstrom-Sammelschiene (P) aus dem Tank in dessen oberem Bereich durch eine Öffnung (BR2, BR3, BR4) eines anderen Abzweigrohres herausgeführt ist.

3. Vorrichtung nach Anspruch 1 oder 2, dadurch gekennzeichnet, daß die Ausgangsseiten der Ventile (U, V, W) und der Überspannungsableiter (LA1, LA2, LA3) mit Verbindungsleitern (J4, J5, J6) verbunden sind, die gemeinsam an einen Verbindungsleiter (J7) angeschlossen sind, der mit der Gleichstromsammelschiene (P) verbunden ist.

4. Vorrichtung nach einem der Ansprüche 1 bis 3, dadurch gekennzeichnet, daß eine Kühleinrichtung (CL) vorgesehen und mit dem einzigen dichten Tank (TA) verbunden ist, um das Isoliermedium (INS) und die Ventile (U, V, W) im Innenraum des dichten Tanks (TA) zu kühlen.

5. Vorrichtung nach einem der Ansprüche 1 bis 4, dadurch gekennzeichnet, daß an einer Basis (BS) des dichten Tanks (TA) Isolierstützen (IP1, IP2) befestigt sind, welche die Ventile (U, V, W) und die Überspannungsableiter (LA1, LA2, LA3) abstützen, während sie diese gegenüber dem dichten Tank (TA) isolieren.

# FIG. 1

# FIG. 2

# FIG. 3

# FIG. 4

# F I G. 5

# FIG. 6

# FIG. 7